# EUROPEAN PATENT APPLICATION

(11) **EP 2 028 522 A1**
(43) Date of publication of application: **25.02.2009**
(21) Application number: 07742085.9
(22) Date of filing: 20.04.2007
(51) Int. Cl.: G02B 26/06, G02B 26/08, G02B 5/08, G21K 1/06, H01L 21/027

(54) **OPTICAL ELEMENT AND OPTICAL DEVICE**

(30) Priority: 12.06.2006 JP 2006162072
(71) Applicant: Kabushiki Kaisha Toshiba, Minato-ku, Tokyo 105-8001 (JP)
(72) Inventor: TAWARAYAMA, Kazuo, (JP); HIGASHIKI, Tatsuhiko, (JP); HIGASHIKAWA, Iwao, (JP)
(74) Representative: Dohmen, Johannes Maria Gerardus
(86) International application number: PCT/JP2007/058650
(87) International publication number: WO 2007/145025

(57) **Abstract**

An optical element (40) includes a substrate (10), a magnetostrictive film (11) which is arranged on the substrate, a film thickness of the magnetostrictive film varying in accordance with intensity of a magnetic field, and a reflection film (15) which is arranged on the magnetostrictive film (11) and reflects light. An optical apparatus includes a stage (41) including a holder (141) for carrying the optical element (40), provided with a plurality of holes arranged in a carrying surface thereof for carrying the optical element, a plurality of magnetic field generation parts (61) embedded in the plurality of holes of the holder (141), and a control mechanism (150) for controlling the magnetic field generated by each of the plurality of magnetic field generation parts (61), and controlling the film thickness of the magnetostrictive film (11) of the optical element (40).

## Description

### Technical Field

The present invention relates to an optical technique, and more particularly, to an optical element and an optical apparatus.

### Background Art

In recent years, the improvement in the finer microstructure of the semiconductor device has been further advanced, and even use of extreme ultraviolet (EUV) light having a wavelength of 5 to 15 nm in an exposure system for manufacturing a semiconductor device is now considered. However, EUV light is easily absorbed into all the substances. Further, when the EUV light is used, a refractive index of the substance becomes in the vicinity of 1.0, and hence a dioptric system that has been used in the conventional exposure system cannot be used. For this reason, in an exposure system in which EUV light is used, a catoptric system constituted of a plurality of mirrors is employed. However, the reflectance of a mirror for EUV light is normally about 70%, and 30% of energy of EUV light incident on the mirror is absorbed into the mirror, thereby causing thermal expansion. For this reason, a method in which an air bag is arranged inside the mirror, and deformation of the mirror resulting from the thermal expansion is corrected by the expansion/contraction of the air bag is proposed (see, for example, Jpn. Pat. Appln. KOKAI Publication No. 2004-56125). However, it has been difficult to control the expansion/contraction of the air bag in the order of nanometer, and by extension it has been impossible to control the surface roughness of the mirrors surface in the order of nanometer.

Thus, realization of an optical element and an optical apparatus capable of controlling the surface roughness with a high degree of accuracy has been desired.

### BRIEF SUMMARY OF THE INVENTION

An optical element of the present invention is characterized by comprising: a substrate; a magnetostrictive film which is arranged on the substrate, a film thickness of the magnetostrictive film varying in accordance with intensity of a magnetic field; and a reflection film which is arranged on the magnetostrictive film and reflects light.

An optical apparatus of the present invention is characterized by comprising: a stage including a holder provided with a plurality of holes arranged in a carrying surface thereof for carrying an optical element provided with a magnetostrictive film which is arranged on a substrate, a film thickness of the magnetostrictive film varying in accordance with intensity of a magnetic field, and a reflection film arranged on the magnetostrictive film and reflecting light; a plurality of magnetic field generation parts embedded in the plurality of holes of the holder; and a control mechanism for controlling the magnetic field generated by each of the plurality of magnetic field generation parts, and controlling the film thickness of the magnetostrictive film of the optical element.

### Brief Description of Drawings

FIG. 1 is a schematic view showing an exposure system according to a first embodiment of the present invention.
FIG. 2 is a top view of a mask stage according to the first embodiment.
FIG. 3 is a cross-sectional view of the mask stage according to the first embodiment.
FIG. 4 is a cross-sectional view of a mask according to the first embodiment.
FIG. 5 is a first schematic view showing a plurality of magnetic domains in the longitudinal section of a magnetostrictive film according to the first embodiment.
FIG. 6 is a first cross-sectional view of the mask stage and the mask according to the first embodiment.
FIG. 7 is a first cross-sectional view of the mask stage and the mask according to the first embodiment.
FIG. 8 is a second schematic view showing a plurality of magnetic domains in the longitudinal section of a magnetostrictive film according to the first embodiment -
FIG. 9 is a graph showing the characteristics of the magnetostrictive film according to the first embodiment.
FIG. 10 is a cross-sectional view of a mask for explaining a method of manufacturing the mask according the first embodiment.
FIG. 11 is a cross-sectional view of the mask of the step succeeding FIG. 10.
FIG. 12 is a cross-sectional view of the mask of the step succeeding FIG. 11.
FIG. 13 is a cross-sectional view of the mask of the step succeeding Fig. 12.
FIG. 14 is a cross-sectional view of the mask of the step succeeding FIG. 13.
FIG. 15 is a cross-sectional view of the mask of the step succeeding FIG. 14.
FIG. 16 is a cross-sectional view of the mask of the step succeeding FIG. 15.
FIG. 17 is a cross-sectional view of the mask of the step succeeding FTG. 16.
FIG. 18 is a cross-sectional view of the mask of the step succeeding FIG. 17.
FIG. 19 is a flowchart for explaining a method of manufacturing a semiconductor device according to the first embodiment.
FIG. 20 is a cross-sectional view of a reflecting mirror according to a second embodiment.

### DETAILED DESCRIPTION OF THE INVENTION

Embodiments of the present invention will be described below with reference to the accompanying drawings. In the description of the following drawings, the same or similar parts are denoted by the same or similar reference symbols. Incidentally, the following embodiments exemplify the devices and methods for embodying the technical idea of the present invention, and the technical idea of the present invention does not specify the arrangements or the like of the constituent components to limit them to the following.

### (First embodiment)

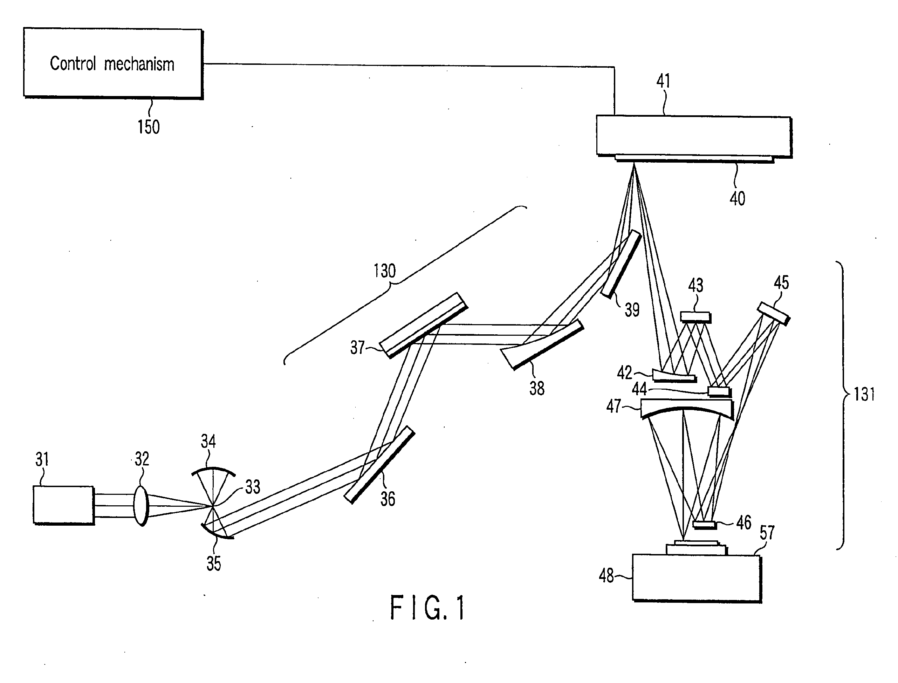

An optical apparatus according to a first embodiment of the present invention is an exposure system for manufacturing a semiconductor device. As shown in FIG. 1, the exposure system includes a light source 31 for emitting light, an illumination optical system 130 for propagating light emitted from the light source 31, and a mask stage 41 for holding a mask 40 irradiated with the light propagated by the illumination optical system 130.

Further, the exposure system includes a projection optical system 131 for propagating light reflected by the mask 40, and a wafer stage 48 for holding a wafer 57 coated with a resist film to be exposed to the light propagated by the projection optical system 131.

The light source emits laser light having wavelengths from the infrared range to the visible range. For example, an yttrium-aluminum-garnet (YAG) laser, excimer laser, or the like by the semiconductor laser excitation is emitted from the light source 31.

A condensing lens 32 is arranged adjacent to the light source 31. The condensing lens 32 condenses the laser light emitted from the light source 31 at a focal point 33. The focal point 33 is supplied with xenon (Xe) gas. The Xe gas is brought to a high temperature by being irradiated with laser light. Further, the Xe is excited to a plasmatic state, and when the Xe makes the transition to a low-potential state, EUV light in the soft X-ray range having a wavelength of 12 to 14 nm is released. The released EUV light is condensed by an elliptical mirror 34, and is reflected by a parabolic mirror 35.

The illumination optical system 130 by which the EUV light reflected by the parabolic mirror 35 is propagated includes reflecting mirrors 36 and 37, a condenser mirror 38, and a light path folding mirror 39. The EUV light is reflected by the reflecting mirrors 36 and 37, further the EUV light reflected and condensed by the condenser mirror 38 is reflected by the light path folding mirror 39, and then reaches a mask 40 fixed to the mask stage 41 by the electrostatic attraction force.

The projection optical system 131 is arranged below the mask 40. Further, the wafer stage 48 for holding a wafer 57 is arranged below the projection optical system 131. The projection optical system 131 includes a condenser mirror 47.

The EUV light reflected by the mask 40 is reflected and condensed by a condenser mirror 42, and is reflected by light path folding mirrors 43 and 44. Further, the EUV light is reflected and condensed by a condenser mirror 45, and is reflected by a light path folding mirror 46. The EUV light reflected by the light path folding mirror 46 is reflected and condensed by a condenser mirror 47, and then converges into a focus on a resist film applied to the surface of the wafer 57. The magnification of the projection optical system 131 is, for example, 1/4. The EUV light is absorbed into air, and hence it is desirable that the environment of the illumination optical system 130, the projection optical system 131, and the like be maintained in a vacuum.

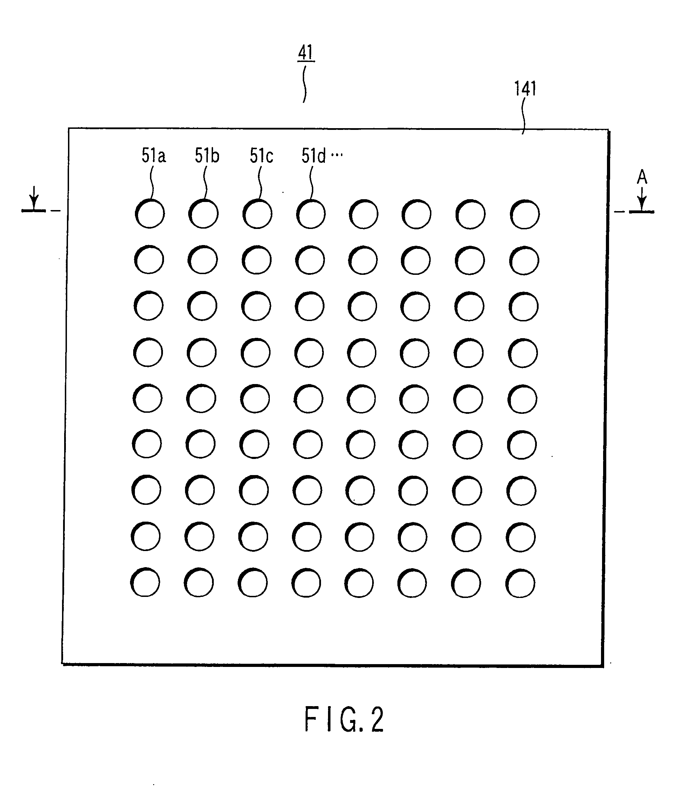

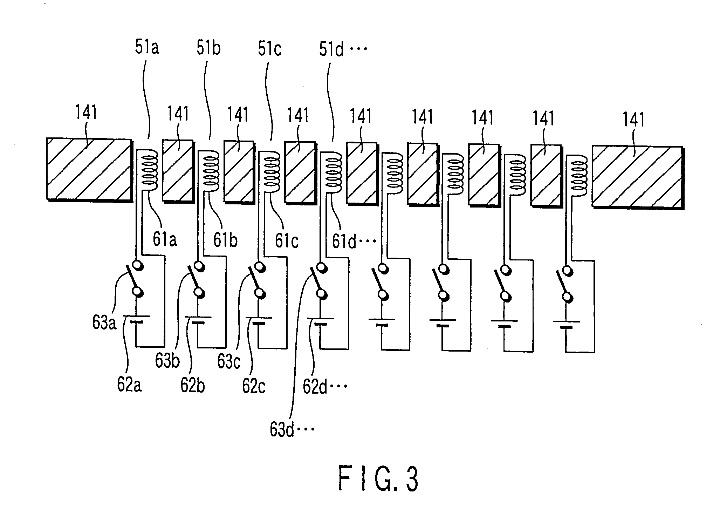

As shown in the top view of FIG. 2, the mask stage 41 includes a support body 141 provided with a plurality of openings 51 (51a, 51b, 51c, 51d, ...) in a matrix form. As shown in FIG. 3 which is a cross-sectional view viewed from the A-A direction, a plurality of magnetic field generation parts 61 (61a, 61b, 61c, 61d, ...) are arranged inside the plurality of openings 51. As each of the plurality of magnetic field generation parts 61, a magnetic coil or the like can be used.

A power source 62 (62a, 62b, 62c, 62d, ...) and a switch 63 (63a, 63b, 63c, 63d, ...) are connected to each of the plurality of magnetic field generation parts 61. For example, when the switch 63a is turned on, a current is supplied from the power source 62a to the magnetic field generation part 61a, and a magnetic field is generated by the magnetic field generation part 61a. The above applies to the magnetic field generation parts 61b, 61c, and so forth.

Each of the plurality of switches 63 and each of the plurality of power sources 62 are connected to a control mechanism 150 shown in FIG. 1. The control mechanism 150 controls opening/closing of each of the plurality of switches 63, and the magnitude of a current supplied by each of the plurality of power sources 62, and controls the magnitude of a magnetic field generated by each of the plurality of magnetic field generation parts 61.

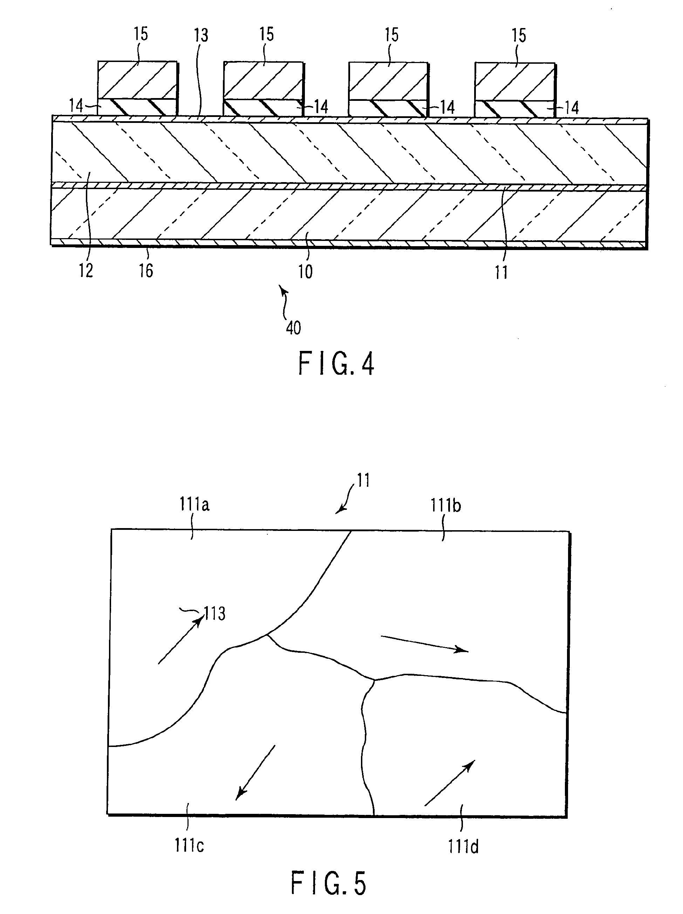

The mask 40 which is an optical element according to the first embodiment includes, as shown in FIG. 4, a substrate 10, a magnetostrictive film 11 which is arranged on the substrate 10, the film thickness of the magnetostrictive film varying in accordance with the intensity of the magnetic field, a reflection film 12 which is arranged on the magnetostrictive film 11 and reflects EUV light, a reflection film 12 which is partly arranged on the reflection film 12 and reflects EUV light, and an absorption film 15 which is partly arranged on the reflection film 12 and absorbs EUV light. Incidentally, although the magnetostrictive film 11 is arranged between the reflection film 12 and the substrate 10, the film 11 may be arranged on the reflection film 12.

As a material for the substrate 10, a low thermal expansion material (LTEM) such as molten silica (Si) doped with titanium (Ti) can be used. As a material for the magnetostrictive film 11, iron group elements such as iron (Fe), cobalt (Co), nickel (Ni), and the like, or lanthanoids such as lanthanum (La), cerium (Ce), praseodymium (Pr), neodymium (Nd), promethium (Pm), samarium (Sm), europium (Eu), thulium (Tm), ytterbium (Yb), and lutetium (Lu), or a Heusler alloy (an alloy containing, for example, Mn, Al, and Cu) can be used.

The reflection film 12 is a multilayer film formed by alternately accumulating Mo thin films made of molybdenum (Mo) and Si thin films made of silicon (Si) one on top of the other to form a multilayer structure of 40 to 50 layers. For example, the film thickness of an Mo thin film and an Si thin film forming a pair is 6.6 nm. Further, the ratio of the film thickness of the Mo thin film to the film thickness of the paired Mo thin film and the Si thin film is 0.33.

A protective film 13 for preventing oxidation and the like of the reflection film 12 is arranged on the reflection film 12. As a material for the protective film 13, Si, ruthenium (Ru) or the like can be used. An intermediate layer 14 is partly arranged on the protective film 13. The intermediate layer 14 is arranged to protect the reflection film 12 and the protective film 13 from dry etching when the absorption film 15 is formed on the reflection film 12.

As a material for the intermediate layer 14, silane oxide (SiO₂) and the like can be used. As a material for the absorption film 15, aluminum (Al), tantalum nitride (TaN), tungsten (W), and the like can be used. The intermediate layer 14 and the absorption film 15 are partly arranged on the reflection film 12 to be correspondent to a circuit pattern of the semiconductor device to be manufactured.

Incidentally, the mask 40 is fixed to the mask stage 41 shown in FIG. 1 with the surface on which the absorption film 15 is arranged directed downward. On the surface of the substrate 10 opposite to the surface on which the magnetostrictive film 11 is arranged, a conductive film 16 is arranged. By arranging the conductive film 16 on the substrate 10, it becomes possible to fix the mask 40 to the mask stage 41 by the electrostatic attraction force.

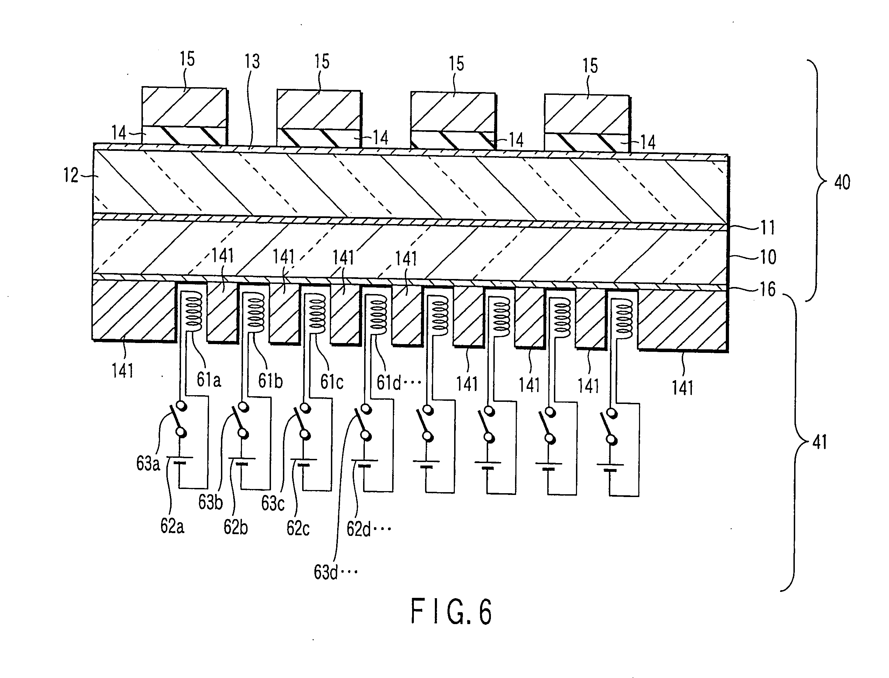

As shown in FIG. 5, the magnetostrictive film 11 is constituted of a plurality of magnetic domains 111a, 111b, 111c, 111d, and the like. As shown in FIG. 6, when each of the plurality of switches 63a to 63d is opened, no magnetic field is applied to the magnetostrictive film 11. When no magnetic field is applied, the plurality of magnetic domains 111a to 111d in the longitudinal section of the magnetostrictive film 11 have various magnetization directions 113 as shown in FIG. 5.

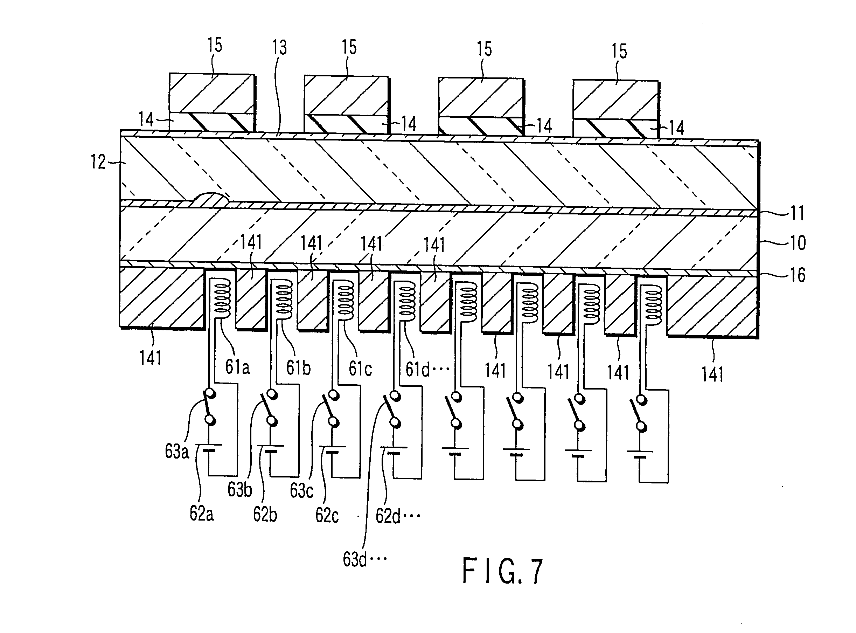

Conversely, for example, in the case where there is a concave part on the undersurface of the reflection film 12 as shown in FIG. 7, when the switch 63a is closed, and a magnetic field is generated by the magnetic field generation part 61a, a magnetic field is applied to a part of the magnetostrictive film 11 above the magnetic field generation part 61a, the film thickness of the film 11 varies, and the film 11 changes its shape to fill the concave part of the reflection film.

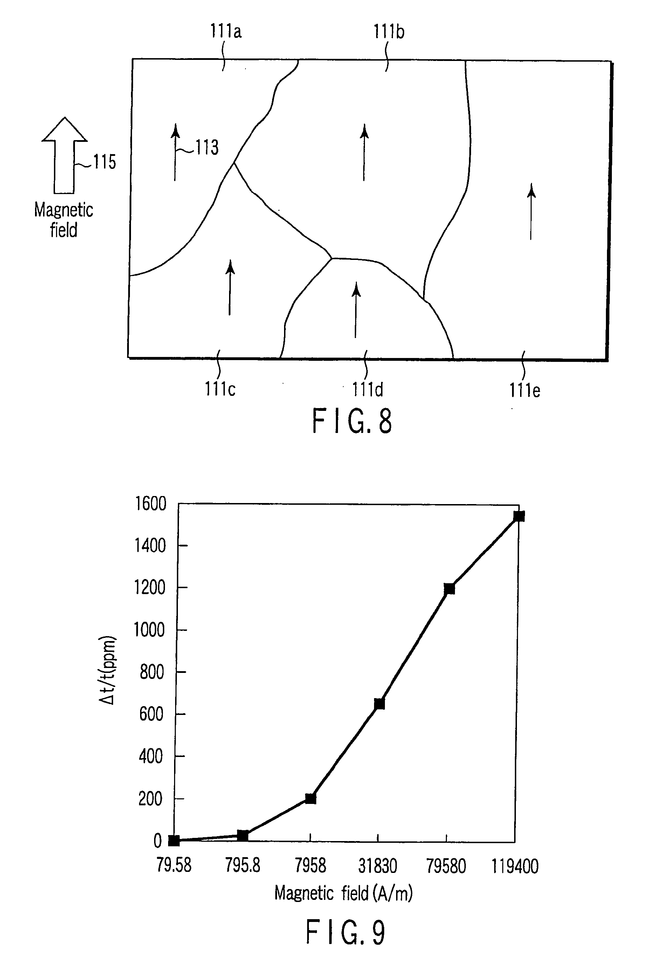

The mechanism which changes the film thickness of the magnetostrictive film 11 will be described below in more detail. When the magnetic field is applied to the magnetostrictive film 11, the magnetization directions 113 of the plurality of magnetic domains 111a to 111d are made uniform so as to be coincident with the direction 115 of the magnetic field as shown in FIG. 8. Accordingly, each of the plurality of magnetic domains 111a, 111b, 111c, and 111d changes its shape, and extends in the direction 115 of the magnetic field. Assuming that the film thickness of the magnetostrictive film 11 in the case where no magnetic field is applied is t, and an increment in the film thickness of a part of the magnetostrictive film 11 to which the magnetic field is applied is Δt, the relationship between the magnetic field and the increment Δt in the film thickness t of the magnetostrictive film 11 is given by FIG. 9.

When light is absorbed into the absorption film 15 and the reflection film 12 of the mask shown in FIG. 4, the film thicknesses of the absorption film 15 and the reflection film 12 are changed by the thermal expansion, and the height position of the absorption film 15 is changed. When the height position of the absorption film 15 is changed, the position of the projection image of the mask 40 on the wafer 57 shown in FIG. 1 is deviated, and a manufacturing error of the semiconductor device is caused. Further, when the film thicknesses of the absorption film 15 and the reflection film 12 are changed by the thermal expansion, an aberration or flare is caused in the projection optical system 131 shown in FIG. 1 in some cases.

Further, when the substrate 10 of the mask 40 is not flat because of a defect or the like, or when the support body 141 of the mask stage 41 is curved, or when there are particles such as dust or the like between the mask 40 and the mask stage 41, too, the image on the mask 40 on the wafer 57 shown in FIG. 1 is shifted.

Conversely, the film thickness of the magnetostrictive film 11 of the mask 40 shown in FIG. 6 can be partly expanded or contracted by each of the plurality of magnetic field generation parts 61a to 61d of the exposure system. Therefore, even when the absorption film 15 or the reflection film 12 is thermally expanded, it becomes possible to correct the position of the reflection film 12 or correct the aberration of the projection optical system 131. Thus, it becomes possible to correct the positional deviation of the projection image of the mask 40 on the wafer 57 shown in FIG. 1 or correct distortion of the projection image caused by the aberration.

Further, the film thickness of the magnetostrictive film 11 of the mask 40 shown in FIG. 6 is not controlled by mechanical drive, and is controlled by magnetic fields generated by the plurality of magnetic field generation parts 61. Accordingly, it becomes possible to easily control the film thickness of the magnetostrictive film 11 even in a vacuum without causing crosstalk.

Furthermore, the plurality of magnetic field generation parts 61 are provided in the mask stage, and hence it is not necessary to provide the mask 40 with a complicated mechanism for controlling the film thickness other than the magnetostrictive film 11. It is also unnecessary to provide electric wiring or mechanical connection between the mask 40 and the mask stage 41. Accordingly, it becomes possible to hold down the manufacturing cost of the semiconductor device. Although in the manufacturing job site of the semiconductor device, replacement of the mask is frequently performed, the manufacturing cost of the semiconductor device can be held down by using the mask 40 according to this embodiment.

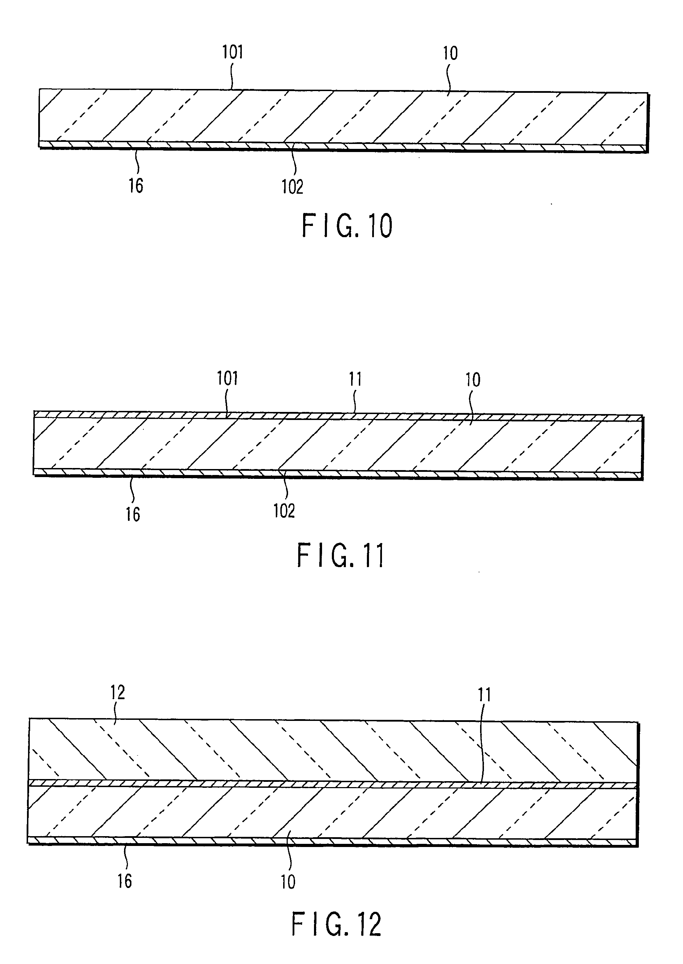

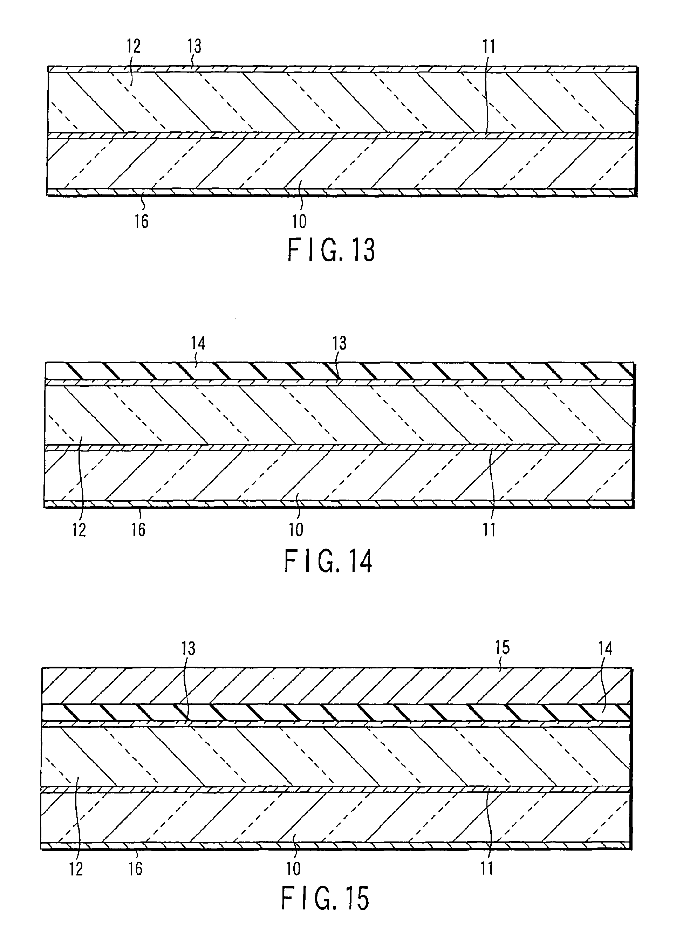

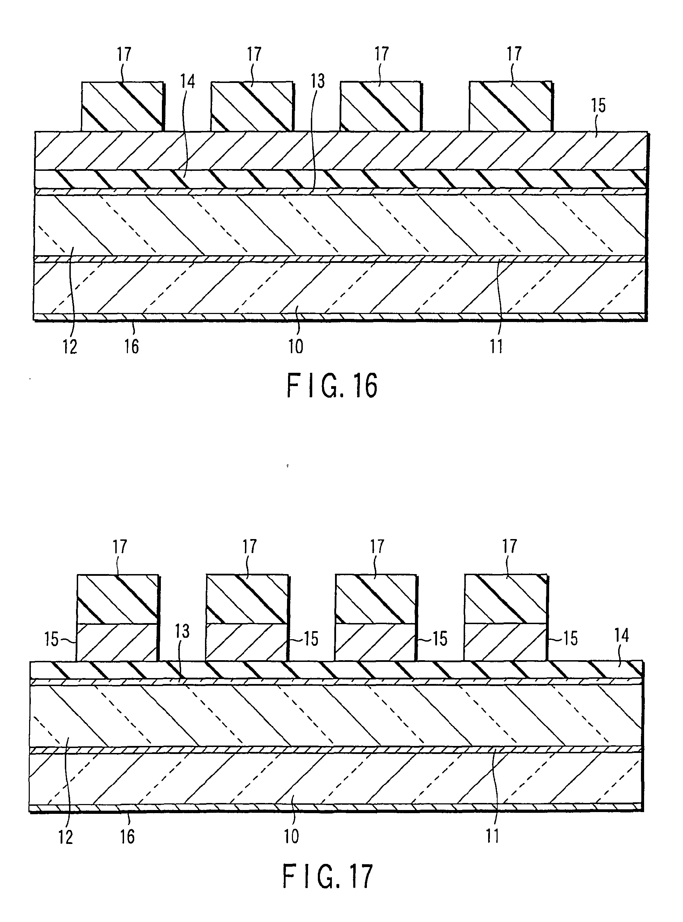

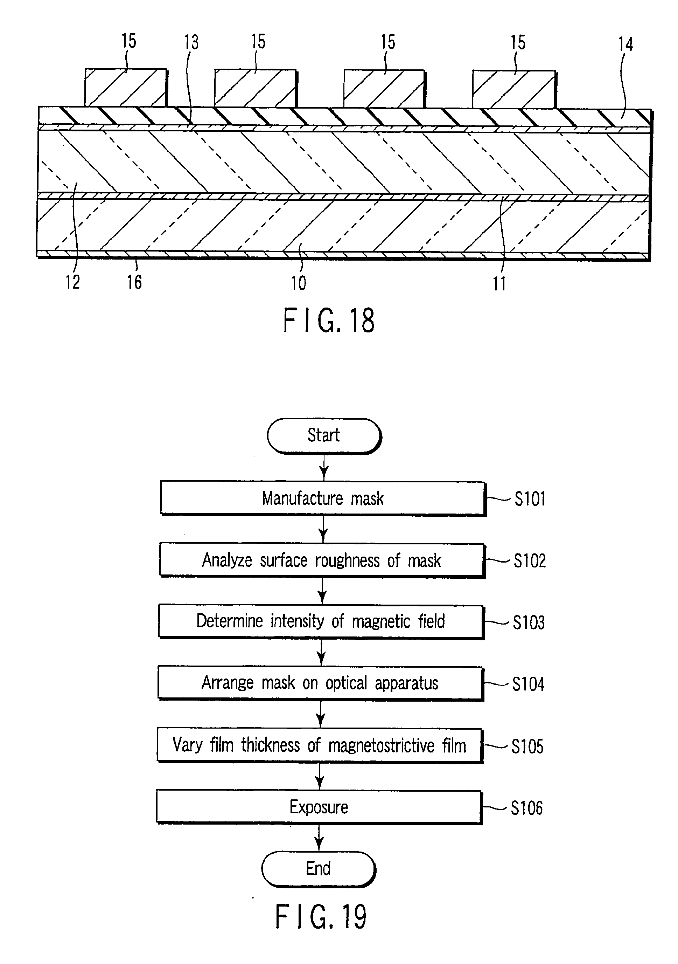

Next, with reference to FIGS. 10 to 18, the method of manufacturing the mask according to this embodiment will be described below.
(a) First, a substrate 10 shown in FIG. 10 having a first principal surface 101 and a second principal surface 102 opposed to the first principal surface is prepared. Then, a conductive film 16 is formed on the second principal surface 102 of the substrate 10 by a vapor deposition method or the like. Thereafter, a magnetostrictive film 11 manufactured by a powder metallurgical process or the like is prepared, and the magnetostrictive film 11 is brought into close contact with the first principal surface 101 of the substrate 10 as shown in FIG. 11.
(b) As shown in FIG. 12, an Si thin film is formed on the magnetostrictive film 11 by the magnetron sputtering method in an argon (Ar) gas environment by using an Si target. Then, an Mo thin film is formed on the Si thin film in the Ar gas environment by using an Mo target. Thereafter, formation of an Mo thin film and formation of an Si thin film are alternately repeated, thereby forming a reflection film 12 on the magnetostrictive film 11. Thereafter, a protective film 13 shown in FIG. 13 is formed on the reflection film 12 in the Ar gas environment by using an Si target.
(c) As shown in FIG. 14, SiO₂ is deposited on the protective film 13 by the chemical vapor deposition (CVD) method or the like, thereby forming an intermediate layer 14. Then, as shown in FIG, 15, Al is accumulated on the intermediate layer 14 by the sputtering method or the like, thereby forming an absorption film 15. As shown in FIG. 16, the absorption film 15 is coated with a resist film by spin coating, an opening pattern is provided on the resist film by the lithography method or the like, thereby forming an etching mask 17 on the absorption film 15.
(d) As shown in FIG. 17, a plurality parts of the absorption film 15 exposed to the outside from the etching mask 17 are selectively removed by the dry etching method or the like using Ar gas. At this time, the protective film 13 is protected by the intermediate layer 14- Thereafter, the etching mask 17 is removed from the surface of the absorption film 15 by the ashing method or the like. As shown in FIG. 18, by using the absorption film 15 from which the plural parts have already been selectively removed as a mask, the exposed parts of the intermediate layer 14 are selectively removed by the anithotropic etching method or the like, thereby completing the mask 40 shown in FIG. 4.

Next, the method of manufacturing the semiconductor device according to this embodiment will be described below with reference to the flowchart of FIG. 19.
(a) In step S101, in accordance with the procedures described previously with reference to FIGS. 10 to 18, the mask 40 shown in FIG. 4 is manufactured. In step S102, the surface roughness of the absorption film 15 and the protective film 13 of the mask 40 is analyzed by using a surface analyzer such as a scanning electron microscope (SEM), an atomic force microscope (AFM), and the like. When there is a protrusion or a recess having a size exceeding the permissible value on the absorption film 15 and the protective film 13, the size of the protrusuion or the recess is measured by the surface analyzer.
(b) In step S103, the intensity of the magnetic field to be applied to the magnetostrictive film 11 in order to correct the protrusion or the recess of the absorption film 15 and the protective film 13 is determined by using the relationship between the magnetic field and the amount of variation in the film thickness of the magnetostrictive film 11 which is shown in FIG. 9, and is obtained in advance. Then, in step S104, the mask 40 is fixed to the mask stage 41 of the exposure system as shown in FIG. 6.
(c) In step S105, the control mechanism 150 shown in FIG. 1 controls opening/closing of each of the plurality of switches 63 shown in FIG. 6 in such a manner that a magnetic field generation part of the plural magnetic field generation parts 61 in the vicinity of the protrusion or the recess of the absorption film 15 and the protective film 13 generates a magnetic field. Further, the control mechanism 150 shown in FIG. 1 controls the magnitude of a current supplied to each of the plural magnetic field generation parts 61 from each of the plural power sources 62 shown in FIG. 6 in such a manner that the magnetic field having the intensity determined in step S103 is generated. By applying the magnetic field to the magnetostrictive film 11, the film thickness of the magnetostrictive film 11 is varied, thereby correcting the protrusion or the recess of the absorption film 15 and the protective film 13.
(d) In step S106, a wafer 57 coated with a resist film by spin coating is arranged on the wafer stage 48 shown in FIG. 1. Then, laser light is emitted from the light source 31, and the mask 40 is irradiated with EUV light generated at the focal point 33 in the Xe gas environment. The EUV light reflected by the mask 40 forms a projection image of the mask 40 on the wafer 57 through the projection optical system 131. Thereafter, through a development process of the resist film, the wiring step, and the like, the semiconductor device is completed.

Incidentally, the thermal expansion of the reflection film 12 of the mask 40 may be predicted by a simulation or the like in step S102 of FIG. 19, and a magnetic field may be applied to the magnetostrictive film 11 to correct the thermal expansion of the reflection film 12 in step S105.

According to the method of manufacturing the semiconductor device shown above, even when a protrusion or a recess is present in the absorption film 13, the protective film 13, or the reflection film 12, it becomes possible to correct the protrusion or the recess of the absorption film 15 and the protective film 13 by controlling the film thickness of the magnetostrictive film 11. Accordingly, it becomes possible to make the allowable range of the surface roughness of the absorption film 15 and the protective film 13 wide at the time of manufacturing the mask 40. Therefore, it becomes possible to reduce the manufacturing cost of the mask 40, and improve the manufacturing yield of the mask 40.

Further, the substrate 10 of the mask 40 shown in FIG. 6 is not always flat, and is curved in some cases. Further, there are cases where a plurality of masks 40 corresponding to different circuit patterns are manufactured, and the mask 40 on the mask stage 41 is successively replaced with another to thereby manufacture a semiconductor device. However, the degrees of the curved states of substrates 10 of a plurality of masks do not coincide with each other in some cases. However, when the degree of the curved state of the substrate 10 or the support body 141 is also measured in step S102 of FIG. 19, and a magnetic field is applied to the magnetostrictive film 11 so that the curve can be corrected in step S105, it becomes possible to form a projection image equivalent to the projection image obtained by using a just designed mask 40 on the wafer 57 shown in FIG. 1.

### (Second embodiment)

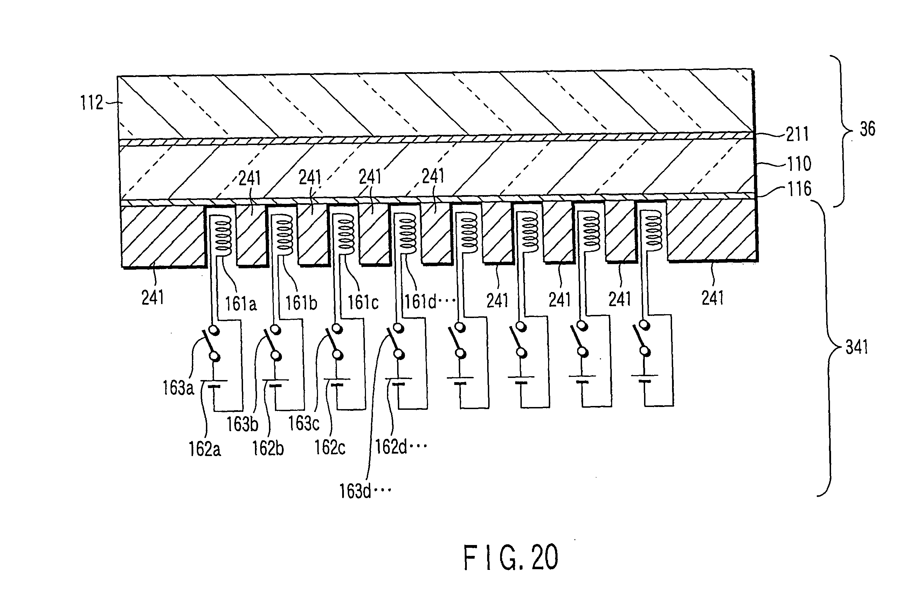

In the first embodiment, although the mask 40 shown in FIG. 4 has been described as an optical element provided with a magnetostrictive film, an optical element provided with a magnetostrictive film can also be applied to, for example, a reflecting mirror 36 shown in FIG. 1. FIG. 20 is a schematic view showing the configuration of a reflecting mirror (device) according to a second embodiment of the present invention.

As shown in FIG. 20, a reflecting mirror 36 according to the second embodiment includes a substrate 110, a magnetostrictive film 211 arranged on the substrate 110, and a reflection film 112 arranged on the magnetostrictive film 211. The reflecting mirror 36 further includes a conductive film 116 on the underside thereof, and is fixed to a reflecting mirror stage 341 by the electrostatic attraction force or the like. Incidentally, although the magnetostrictive film 211 is arranged between the reflection film 112 and the substrate 110, the film 211 may be arranged in the reflection film 112.

The reflecting mirror stage 341 includes, as in the case of the first embodiment, a support body 241 provided with a plurality of openings, a plurality of magnetic field generation parts 161 (161a, 161b, 161c, 161d, . . .) inserted in the plurality of openings of the support body 241, a plurality of power sources 162 (162a, 162b, 162c, 162d, ...) connected to the plurality of magnetic field generation parts 161, and a plurality of switches 163 (163a, 163b, 163c, 163d, ...) each of which is arranged between each of the plurality of magnetic field generation parts 161 and each of the plurality of power sources 162 to be connected to the corresponding magnetic field generation part 161 and the corresponding power source 162.

For example, when an aberration or flare is caused in the projection optical system 131 shown in FIG. 1, a magnetic field is generated by each of the plurality of magnetic field generation parts 161 shown in FIG. 20 to adjust the film thickness of the magnetostrictive film 211 of the reflecting mirror 36, whereby the aberration or falare can be removed.

As described above, according to the second embodiment, it is possible to provide a reflecting mirror capable of controlling the surface roughness with a high degree of accuracy.

### Industrial Applicability

In the embodiments described above, although the exposure system and the reflecting mirror have been described as the optical apparatus, besides the present invention can be applied to an optical microscope, a hologram formation apparatus, and the like.

## Claims

1. An optical element **characterized by** comprising:
a substrate;
a magnetostrictive film which is arranged on the substrate, a film thickness of the magnetostrictive film varying in accordance with intensity of a magnetic field; and
a reflection film which is arranged on the magnetostrictive film and reflects light.

2. The optical element according to claim 1, **characterized in that** the substrate is formed of a material that transmits the light.

3. The optical element according to any one of claims 1 to 2, **characterized in that** the magnetostrictive film includes at least one of Fe, Co, Ni, La, Ce, Pr, Nd, Pm, Sm, Eu, Gd, Tb, Dy, Ho, Er, Tm, Yb, Lu, Mn, Al, and Cu.

4. The optical element according to any one of claims 1 to 3, **characterized in that** the reflection film is a multilayer film formed by alternately accumulating Mo thin films and Si thin films one on top of the other.

5. The optical element according to any one of claims 1 to 4, **characterized by** further comprising an absorption film selectively formed on the reflection film and absorbing the light.

6. The optical element according to claim 5, **characterized in that** the absorption film forms a mask pattern.

7. The optical element according to claim 5 or 6, **characterized in that** the absorption film is formed of one of Al, TaN, and W.

8. The optical element according to any one of claims 5 to 7, **characterized by** further comprising a first protective film and a second protective film formed between the reflection film and the absorption film.

9. The optical element according to claim 8, **characterized in that** the first protective film is formed of Si or Ru.

10. The optical element according to claim 8, **characterized in that** the second protective film is formed of SiO₂.

11. An optical apparatus **characterized by** comprising:
a stage including a holder provided with a plurality of holes arranged in a carrying surface thereof for carrying an optical element provided with a magnetostrictive film which is arranged on a substrate, a film thickness of the magnetostrictive film varying in accordance with intensity of a magnetic field, and a reflection film arranged on the magnetostrictive film and reflecting light;
a plurality of magnetic field generation parts embedded in the plurality of holes of the holder; and
a control mechanism for controlling the magnetic field generated by each of the plurality of magnetic field generation parts, and controlling the film thickness of the magnetostrictive film of the optical element.

12. The optical apparatus according to claim 11, **characterized in that** each of the plurality of magnetic field generation parts includes a coil, a power source, and a switch.

13. The optical apparatus according to claim 11 or 12, **characterized in that** the control mechanism selectively drives the plurality of magnetic field generation parts by using the switches, changes the magnetic field generated by the coil by controlling the power source of a selected one of the magnetic field generation parts, and controls the film thickness of the magnetostrictive film of the optical element.

14. The optical apparatus according to any one of claims 11 to 13, **characterized in that** the plurality of holes provided in the holder are provided in a form of a matrix.

15. The optical apparatus according to any one of claims 11 to 14, **characterized by** further comprising:
a light source;
an illumination optical system for generating conversion light from the light source, and irradiating the optical element with the conversion light; and
a projection optical system for projecting reflected light from the optical element on an object.

16. The optical apparatus according to claim 15, **characterized in that** the light source is a light source for emitting laser light.

17. The optical apparatus according to claim 15 or 16, **characterized in that** the illumination optical system includes a reflection optical system.

18. The optical apparatus according to any one of claims 15 to 17, **characterized in that** the illumination optical system generates extreme ultraviolet light by using the laser light.

19. The optical apparatus according to any one of claims 15 to 18, **characterized in that** the projection optical system includes the reflection optical system.

20. The optical apparatus according to any one of claims 11 to 19, **characterized in that** the magnetostrictive film includes at least one of Fe, Co, Ni, La, Ce, Pr, Nd, Pm, Sm, Eu, Gd, Tb, Dy, Ho, Er, Tm, Yb, Lu, Mn, Al, and Cu.
